## Europäisches Patentamt
## European Patent Office
## Office européen des brevets

(19)

(11) Numéro de publication : **0 150 633 B1**

(12)
# FASCICULE DE BREVET EUROPÉEN

(45) Date de publication du fascicule du brevet :
**17.08.88**

(51) Int. Cl.⁴ : **G 09 G   3/28**

(21) Numéro de dépôt : **84401893.7**

(22) Date de dépôt : **21.09.84**

(54) **Circuit de commande d'un panneau à plasma de type alternatif.**

(30) Priorité : **27.09.83 FR 8315334**

(43) Date de publication de la demande :
**07.08.85 Bulletin 85/32**

(45) Mention de la délivrance du brevet :
**17.08.88 Bulletin 88/33**

(84) Etats contractants désignés :
**DE GB NL**

(56) Documents cités :
**EP-A- 0 069 524**
**EP-A- 0 078 193**
**US-A- 3 851 210**
**US-A- 3 997 813**
**US-A- 4 384 287**
**1976 SID INTERNATIONAL SYMPOSIUM, DIGEST OF TECHNICAL PAPERS, édition 1, mai 1976, pages 58-59, Lewis Winner, New York, US; J.W. MILLER et al.: "Bipolar integrated circuit plasma panel drive system"**

(73) Titulaire : **THOMSON-CSF**
**173, Boulevard Haussmann**
**F-75379 Paris Cédex 08 (FR)**

(72) Inventeur : **Delgrange, Louis**
**THOMSON-CSF SCPI 173, bld Haussmann**
**F-75379 Paris Cedex 08 (FR)**
Inventeur : **Vialettes, Françoise**
**THOMSON-CSF SCPI 173, bld Haussmann**
**F-75379 Paris Cedex 08 (FR)**

(74) Mandataire : **Mayeux, Michèle et al**
**THOMSON-CSF SCPI 19, avenue de Messine**
**F-75008 Paris (FR)**

## Description

La présente invention concerne un circuit de commande d'un panneau à plasma de type alternatif.

Par la demande de brevet français n° 81 19941 (correspondant à la demande EP-A-78 193), déposée le 23 Octobre 1981, et publiée sous le n° 2 515 402, on connaît déjà un circuit de commande d'un panneau à plasma de type alternatif.

Les figures 1, 2 et 3 de la présente demande sont relatives au fonctionnement du circuit décrit dans la demande de brevet n° 2 515 402 à laquelle on se référera pour plus de détails.

Un panneau à plasma comporte deux réseaux d'électrodes orthogonaux, que l'on désigne par les termes électrodes en x et électrodes en y. Les signaux de commande du panneau — signaux d'entretien, d'inscription et d'effacement — sont appliqués entre deux électrodes appartenant à chacun des réseaux.

Le circuit de commande de la demande de brevet n° 2 515 402 est constitué de circuits intégrés et d'amplificateurs.

Les électrodes en x sont commandées par des circuits intégrés qui portent la référence X.

Chaque circuit intégré X est associé à un seul amplificateur.

Les électrodes en y sont commandées par des circuits intégrés qui portent la référence Y.

Chaque circuit intégré Y est associé à deux amplificateurs.

On peut résumer d'une façon un peu schématique le fonctionnement du circuit de commande de la demande de brevet citée en disant que les circuits intégrés assurent l'élaboration des signaux d'inscription et d'effacement du panneau et les amplificateurs assurent l'élaboration de ses signaux d'entretien.

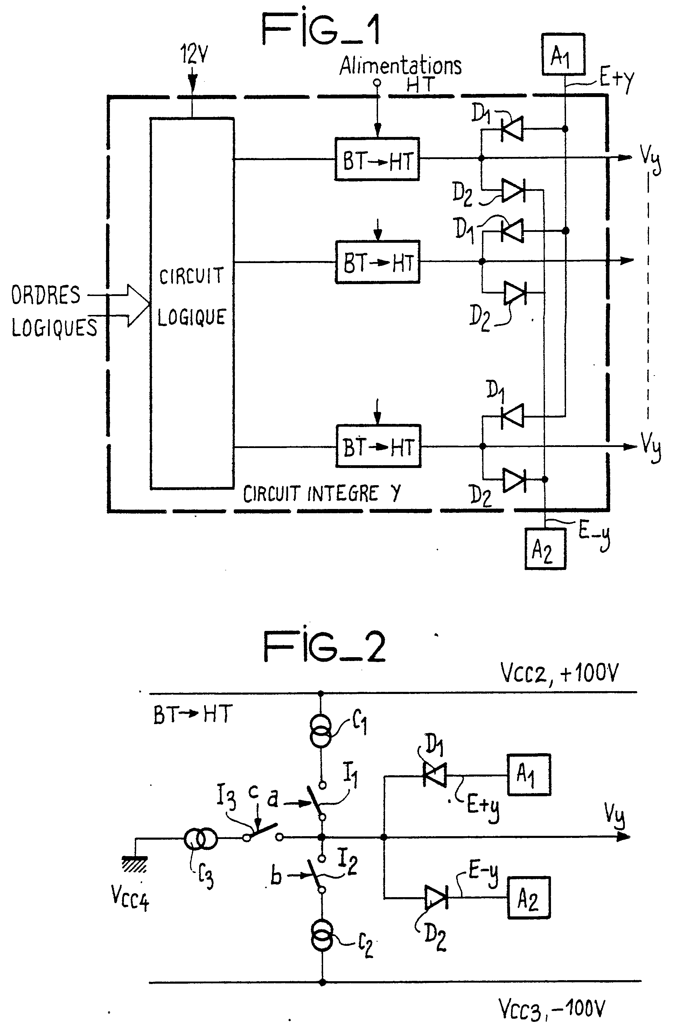

Sur la figure 1 de la présente demande, on a représenté de façon schématique un circuit intégré Y.

Ce circuit intégré comporte trois parties : un circuit logique, un circuit d'interface basse tension/haute tension, et un réseau de diodes.

Le circuit logique reçoit des ordres en logique basse tension définissant le signal à exécuter, sa durée et les électrodes du panneau à adresser. Ce circuit logique est alimenté par une tension continue de 12 V par exemple.

Le circuit d'interface basse tension/haute tension, BT/HT sur la figure 1, est commandé par le circuit logique et permet, lors de l'élaboration de signaux d'inscription et d'effacement, de porter chaque électrode du panneau à une tension donnée. Ce circuit est alimenté en haute tension par des sources de tension continue externes au circuit intégré qui fournissent des tensions de valeurs $V_{CC2}$, $V_{CC3}$, et $V_{CC4}$, égales par exemple à + 100 V, — 100 V et 0 V.

A la suite du circuit d'interface basse tension/haute tension, on trouve un réseau de diodes qui assure la liaison entre, les sorties du circuit d'interface basse tension/haute tension, les sorties $E_{+y}$ et $E_{-y}$ des deux amplificateurs $A_1$ et $A_2$ externes au circuit intégré et les électrodes du panneau-connexions $V_y$.

Chaque sortie d'un circuit d'interface est reliée à deux diodes $D_1$ et $D_2$ montées tête-bêche.

La diode $D_1$ a sa cathode reliée à une sortie du circuit d'interface et son anode reliée à une connexion $E_{+y}$.

La diode $D_2$ a son anode reliée à une sortie du circuit d'interface et sa cathode reliée à une connexion $E_{-y}$.

Sur la figure 2, on a représenté de façon schématique la constitution d'un circuit d'interface basse tension/haute tension dans le cas du circuit intégré Y de la figure 1.

Chaque circuit d'interface comporte trois interrupteurs $I_1$, $I_2$, $I_3$, qui sont commandés par des signaux a, b et c fournis par le circuit logique et qui sont connectés entre une électrode du panneau-connexion $V_y$ et l'une des trois tensions continues $V_{CC2}$, $V_{CC3}$ et $V_{CC4}$. Chacun de ces interrupteurs est monté en série avec une source de courant $C_1$, $C_2$ et $C_3$. On a également représenté sur la figure 2 et bien qu'ils ne fassent pas partie du circuit d'interface basse tension/haute tension, le couple de diodes $D_1$ et $D_2$ associé à chaque circuit d'interface basse tension/haute tension et les amplificateurs $A_1$ et $A_2$.

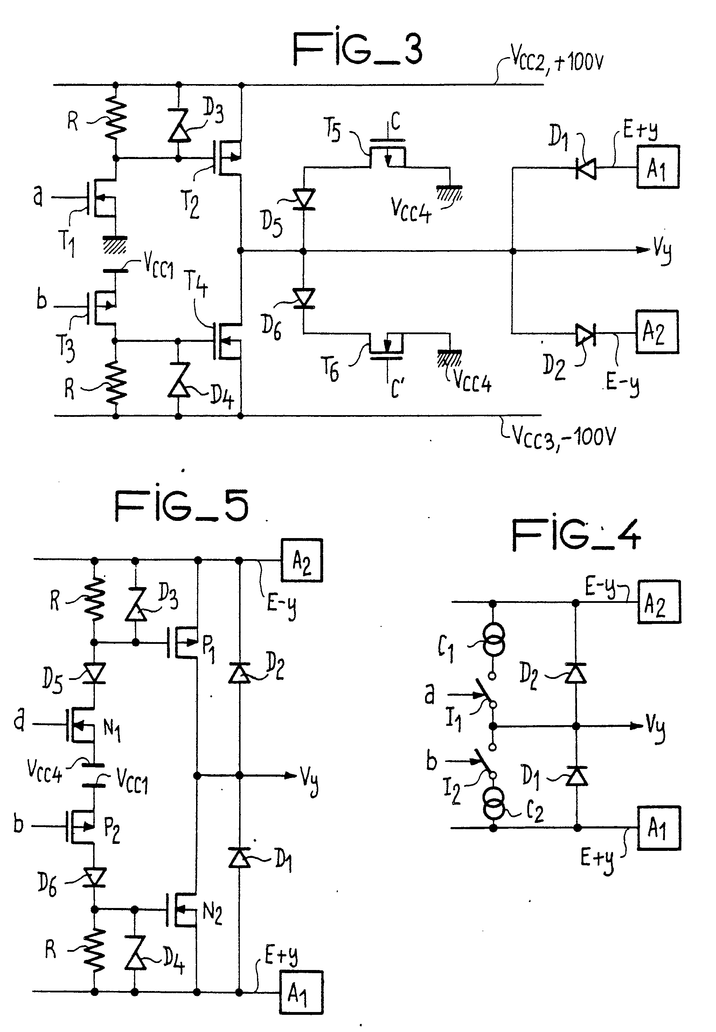

La figure 3 donne un exemple de réalisation du schéma de la figure 2.

Les interrupteurs $I_1$ et $I_2$ et les sources de courant $C_1$ et $C_2$ sont constitués par deux transistors MOS supportant une haute tension ou DMOS, portant les références $T_1$, $T_2$, $T_3$, $T_4$. Il faut aussi deux résistances R et deux diodes zener $D_3$ et $D_4$. Chaque DMOS joue donc le rôle d'un interrupteur en série avec une source de courant. Pour une tension donnée appliquée sur sa grille, il transmet l'une des tensions $V_{CC2}$, $V_{CC3}$ à une connexion $V_y$ et peut fournir un courant drain-source donné.

Pour réaliser l'interrupteur $I_3$ et la source de courant $C_3$, on utilise deux transistors $T_5$ et $T_6$ commandés par des signaux c et c' et deux diodes $D_5$ et $D_6$. Il faut deux transistors de type différent car lors de l'élaboration des signaux sélectifs il faut pouvoir fournir ou accepter du courant de chaque électrode. Les diodes $D_5$ et $D_6$ sont là pour compenser l'effet des diodes intrinsèques des transistors $T_5$ et $T_6$.

On constate donc que chaque circuit d'interface basse tension/haute tension d'un circuit intégré Y nécessite l'utilisation de 6 DMOS et que d'autre part les DMOS $T_2$ et $T_4$ doivent être dimensionnés pour supporter 200 V, c'est-à-dire $V_{CC2}$-$V_{CC3}$, de tension inverse. Pour les autres composants, la tension à supporter n'est que de 100 V, soit $|V_{CC2}|$ ou $|V_{CC3}|$.

Les problèmes que la présente invention se propose de résoudre sont les suivants :
— la réduction de l'encombrement du circuit de commande ;
— la diminution de la tenue en tension exigée des composants.

Les divers modes de réalisation de l'invention résolvent partiellement ou en totalité ces problèmes.

Selon l'invention, on a modifié les circuits d'interface basse tension/haute tension des circuits intégrés Y.

Les circuits intégrés X n'ont pas été modifiés par rapport à ce qui est exposé dans la demande de brevet déjà citée — voir notamment figure 2 de cette demande et son commentaire.

Les circuits intégrés X comportent comme les circuits intégrés Y, un circuit logique, un circuit d'interface basse tension/haute tension et un réseau de diodes.

Par rapport aux circuits intégrés Y, il faut noter que le circuit d'interface basse tension/haute tension des circuits intégrés X ne doit, lors de l'élaboration des signaux d'inscription et d'effacement, porter chaque électrode du panneau qu'à deux états et non trois, un état à 0 V ou $V_{CC4}$ et une rampe de 0 à 100 V, de $V_{CC4}$ à $V_{CC3}$. Il faut noter aussi qu'aucun composant n'a à supporter 200 V de tension inverse.

La présente invention concerne un circuit de commande d'un panneau à plasma de type alternatif qui assure l'élaboration des signaux d'entretien, d'inscription et d'effacement du panneau. Ces signaux sont appliqués entre deux électrodes appartenant à deux réseaux d'électrodes orthogonaux, un premier réseau d'électrodes étant commandé par des circuits intégrés associés à un seul amplificateur et un second réseau d'électrodes étant commandé par des circuits intégrés associés à deux amplificateurs, ces amplificateurs servant à l'élaboration des sigaux d'entretien. Chaque circuit intégré comporte notamment un circuit d'interface basse tension/haute tension, commandé par un circuit logique et comportant des moyens permettant notamment lors de l'élaboration des signaux d'inscription et d'effacement, de porter chaque électrode du panneau à une tension donnée, ce circuit d'interface étant suivi par un réseau de diodes. Selon la revendication 1, les circuits d'interface basse tension/haute tension des circuits intégrés associés au second réseau d'électrodes sont alimentés en haute tension par les deux amplificateurs associés à chacun de ces circuits intégrés. Lors de l'élaboration des signaux d'inscription et d'effacement, l'un des amplificateurs fournit la tension à appliquer aux électrodes sélectionnées à inscrire ou à effacer alors que l'autre amplificateur fournit la tension à appliquer aux électrodes non sélectionnées.

D'autres objets, caractéristiques et résultats de l'invention ressortiront de la description suivante, donnée à titre d'exemple non limitatif et illustrée par les figures annexées qui représentent :
— les figures 1, 2 et 3, des schémas des circuits intégrés Y et des circuits d'interfaces basse tension/haute tension selon l'art antérieur ;
— la figure 4, le schéma de principe selon l'invention des circuits d'interface basse tension/haute tension des circuits intégrés Y ;
— la figure 5, un mode de réalisation du schéma de la figure 4 ;
— les figures 6a à e, divers signaux fournis ou recueillis sur les circuits d'interface basse tension/haute tension des circuits intégrés Y selon un mode de réalisation de l'invention.

Sur les différentes figures, les mêmes repères désignent les mêmes éléments, mais, pour des raisons de clarté, les cotes et proportions des divers éléments ne sont pas respectées.

Les figures 1, 2 et 3 ont été décrites dans l'introduction à la description.

La figure 4 est le schéma de principe selon l'invention d'un circuit d'interface basse tension/haute tension utilisé dans un circuit intégré Y.

Selon l'invention, ces circuits d'interface sont alimentés en haute tension par les deux amplificateurs $A_1$ et $A_2$ associés à chaque circuit intégré Y. Ces circuits d'interface recoivent donc les tensions $E_{+y}$ et $E_{-y}$ fournies par ces deux amplificateurs $A_1$ et $A_2$. Deux interrupteurs $I_1$ et $I_2$ commandés par des signaux logique basse tension a et b permettent d'appliquer à chaque électrode en y — connexion $V_y$ — soit $E_{-y}$ lorsque l'interrupteur $I_1$ est fermé, soit $E_{+y}$ lorsque l'interrupteur $I_2$ est fermé, pour l'élaboration des signaux d'inscription et d'effacement. Ces interrupteurs sont montés en série avec des sources de courant $C_1$ et $C_2$. Lorsque les interrupteurs $I_1$, $I_2$ sont ouverts, les signaux d'entretien sont élaborés comme dans la demande de brevet citée grâce aux diodes $D_1$ et $D_2$ connectées entre d'une part $V_y$ et d'autre part $E_{-y}$ et $E_{+y}$.

Sur la figure 4, on trouve donc en parallèle entre $V_y$ et $E_{-y}$ l'interrupteur $I_1$, en série avec la source de courant $C_1$, et la diode $D_2$ reliée par son anode à $V_y$ et en parallèle entre $V_y$ et $E_{+y}$ l'interrupteur $I_2$, en série avec la source de courant $C_2$, et la diode $D_1$ reliée par sa cathode à $V_y$.

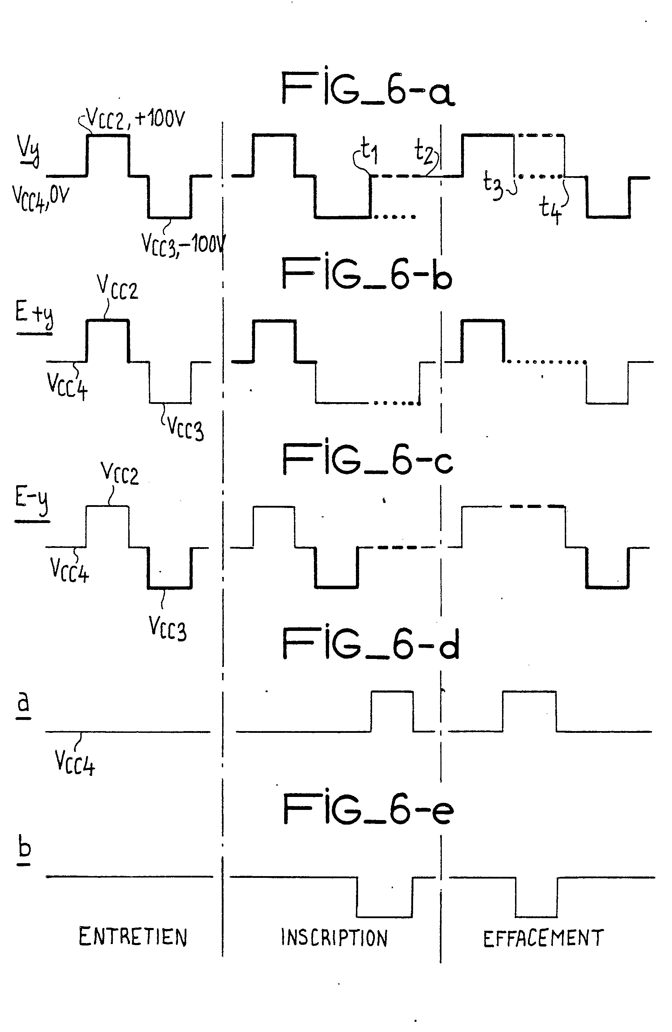

Le fonctionnement du dispositif de la figure 4 va être expliqué en se référant aux figures 6a à e.

Ces figures comportent trois parties :
— la partie de gauche relative aux signaux d'entretien ;
— la partie centrale relative aux signaux d'inscription ;
— la partie de droite relative aux signaux d'effacement.

La figure 6a montre le signal $V_y$ appliqué à une électrode en y.

Les figures 6b et c montrent les tensions $E_{+y}$ et $E_{-y}$ obtenues en sortie des deux amplificateurs reliés à chaque circuit intégré Y et appliquées selon l'invention à chaque circuit d'interface basse tension/haute tension.

Les figures 6d et e montrent les signaux de commande a et b appliqués aux interrupteurs $I_1$ et $I_2$ de la figure 4.

Comme cela a été expliqué dans la demande de brevet déjà citée, les signaux d'entretien, en créneaux de valeurs extrêmes $V_{CC2}$ et $V_{CC3}$, égales par exemple à + 100 V et — 100 V et de

valeur intermédiaire $V_{CC4}$, égale par exemple à 0 V, sont réalisés par deux amplificateurs fournissant des tensions $E_{+y}$ et $E_{-y}$ en créneaux identiques à $V_y$.

Ainsi et grâce aux diodes $D_1$ et $D_2$, l'un des amplificateurs fournit le courant nécessaire au panneau à plasma lors des flancs de montée du signal d'entretien et l'autre amplificateur accepte du courant du panneau lors des flancs de descente du signal d'entretien. L'égalité des tension $E_{+y}$ et $E_{-y}$ fait qu'il n'y a pas de circulation de courant de $E_{+y}$ à $E_{-y}$ par les diodes.

Sur les figures 6b et c, on a représenté en trait épais les portions des signaux $E_{+y}$ et $E_{-y}$ qui sont appliquées aux électrodes en y et en trait mince, les portions des signaux $E_{+y}$ et $E_{-y}$ qui ne servent qu'à éviter la circulation de courant entre $E_{+y}$ et $E_{-y}$, c'est-à-dire entre les deux amplificateurs.

Ainsi l'alternance positive de $E_{+y}$ est appliquée par la diode $D_1$ à une électrode en y, et donc contribue à l'élaboration de l'alternance positive de la tension $V_y$.

Il en est de même pour l'alternance négative de $E_{-y}$.

Lors de l'élaboration des signaux d'entretien, les interrupteurs $I_1$ et $I_2$ sont couverts. Les signaux d'entretien sont élaborés de la même façon que dans l'art antérieur où selon le schéma de la figure 2 de la présente demande, les interrupteurs $I_1$, $I_2$ et $I_3$ étaient ouverts à ce moment-là.

Selon l'invention la Demanderesse a tiré parti des considérations suivantes.

Dans le cas de la figure 2, lors de l'élaboration des signaux d'entretien, par les amplificateurs, les interrupteurs $I_1$, $I_2$ et $I_3$ sont ouverts et lors de l'élaboration des signaux d'inscription et d'effacement, il faut que les tensions $E_{+y}$ et $E_{-y}$ en sortie des amplificateurs soient telles qu'elles n'imposent pas de tensions aux circuits d'interface basse tension/haute tension qui doivent délivrer ces signaux. Sur la figure 6a, on a représenté les signaux d'inscription et d'effacement à élaborer. Les parties en pointillés concernent le cas où une électrode doit être inscrite ou effacée. Les parties en tirets concernent le cas contraire, où l'électrode doit être maintenue dans le même état.

Sur les figures 6b et c, on a représenté les tensions $E_{+y}$ et $E_{-y}$ que doivent fournir les amplificateurs, lors de l'élaboration des signaux d'inscription ou d'effacement pour que les amplificateurs n'imposent pas de tension aux électrodes en y.

Les relations suivantes doivent être vérifiées :

$$E_{+y} \leq V_y$$
$$E_{-y} \geq V_y$$

en tenant compte du fait que $E_{+y}$ est positif et $E_{-y}$ négatif.

$E_{+y}$ et $E_{-y}$ sont pris égaux à $V_y$ sauf dans les zones où $V_y$ peut prendre deux valeurs. Là, $E_{+y}$ prend la plus faible de ces valeurs et $E_{-y}$ la plus forte.

La Demanderesse a remarqué que, pour l'inscription comme pour l'effacement, la tension $E_{+y}$ est égale à la tension $V_y$ — en pointillés — à appliquer aux électrodes sélectionnées — à inscrire ou à effacer — et la tension $E_{-y}$ est égale à la tension $V_y$ — en tirets — à appliquer aux électrodes non sélectionnées.

Selon l'invention, on n'utilise plus les tensions continues de + 100 V, — 100 V de la figure 2 et on utilise dans chaque circuit d'interface basse tension/haute tension, les tensions $E_{+y}$ et $E_{-y}$ pour élaborer les signaux d'inscription et d'effacement. Les tensions $E_{+y}$ et $E_{-y}$ n'ont pas à être modifiées. Elles auront simplement à fournir l'énergie nécessaire aux signaux sélectifs lors de leur élaboration alors que les amplificateurs étaient passifs dans l'art antérieur, lors de l'élaboration des signaux sélectifs. Les courants nécessaires à l'inscription et à l'effacement étant très inférieurs à ceux de l'entretien, cela ne nécessitera pas de surdimensionnement des amplificateurs créant $E_{+y}$ et $E_{-y}$.

Par exemple, lors de l'intervalle de temps $t_1$, $t_2$ destiné à l'inscription :

— lorsqu'une électrode en y doit être inscrite on ferme l'interrupteur $I_2$ pour appliquer $E_{+y}$ à l'électrode, et pour avoir $V_y = E_{+y}$. L'interrupteur $I_2$ est en parallèle sur la diode $D_1$ et impose à l'électrode en y une tension de — 100 V que la diode $D_1$ n'aurait pas permis de lui appliquer, la diode $D_2$ est en inverse ;

— lorsqu'une électrode en y ne doit pas être inscrite, on ferme l'interrupteur $I_1$ pour appliquer $E_{-y}$ à l'électrode et pour avoir $V_y = E_{-y}$. L'interrupteur $I_1$ est en parallèle sur la diode $D_2$ et impose à l'électrode en y une tension de O V que la diode $D_2$ n'aurait pas permis de lui appliquer, la diode $D_1$ est en inverse.

Lors de l'intervalle de temps $t_3$, $t_4$ destiné à l'effacement :

— lorsqu'une électrode en y doit être effacée, on ferme l'interrupteur $I_2$ pour avoir $V_y = E_{+y}$. De même l'interrupteur $I_2$ impose à l'électrode en y une tension de O V que la diode $D_1$ n'aurait pas permis d'appliquer. La diode $D_2$ est en inverse ;

— lorsqu'une électrode en y ne doit pas être effacée, on ferme l'interrupteur $I_1$ pour avoir $V_y = E_{-y}$. De même, l'interrupteur $I_1$ impose à l'électrode en y une tension de + 100 V que la diode $D_2$ n'aurait pas permis d'appliquer. La diode $D_1$ est en inverse.

Les signaux de commande a et b qui commandent les interrupteurs $I_1$ et $I_2$ sont identiques pour l'inscription et l'effacement. L'invention permet donc de simplifier les circuits logiques des circuits intégrés qui fournissent a et b.

L'invention permet de réduire le nombre d'interrupteurs et de sources de courant. Sur la figure 4, on n'utilise que deux interrupteurs et deux sources de courant alors qu'on en utilise trois sur la figure 3.

Enfin, on remarque sur la figure 6 qu'il y a au maximum 100 V de différence de potentiel entre $E_{+y}$ et $E_{-y}$ c'est-à-dire sup $|V_{CC2}|$, $|V_{CC3}|$. Aucun composant ne doit plus supporter 200 V en inverse, c'est-à-dire $|V_{CC2}| + |V_{CC3}|$ comme

c'était le cas sur la figure 2.

Tous les composants peuvent être dimensionnés pour une tenue en tension inverse de 100 V c'est-à-dire de sup $|V_{CC2}||V_{CC3}|$.

L'invention permet donc de réaliser des signaux de sortie d'amplitude. ($V_{CC4}$, $V_{CC2}$) et ($V_{CC4}$, $V_{CC3}$) avec des composants dimensionnés pour une tension inverse de sup ($|V_{CC2}|$ $|V_{CC3}|$) au lieu de composants devant supporter $|V_{CC2}| + |V_{CC3}|$.

Cela représente un gain appréciable dans le dimensionnement des composants et cela permet de dépasser les limites de tension atteintes par la technologie des composants intégrés.

Ainsi dans l'exemple numérique choisi, on crée des signaux d'amplitude totale 200 V à partir de composants supportant 100 V.

Il faut remarquer que cela se fait sans faire flotter la tension de référence $V_{CC4}$ du circuit. Ce dernier point est très important car l'invention ne modifie absolument pas le fonctionnement du circuit logique du circuit intégré, celui-ci étant toujours référencé par rapport à la tension $V_{CC4}$ constante.

La figure 5 est un exemple de réalisation du schéma de principe de la figure 4.

Comme dans le cas de la figure 3, on a réalisé chaque interrupteur, associé à une source de courant, par deux DMOS $N_1$ et $P_1$ pour $I_1$ et $N_2$ et $P_2$ pour $I_2$.

Le transistor $P_1$ du type P est connecté entre la sortie $E_{-y}$ de l'amplificateur $A_2$ et $V_y$.

Entre $E_{-y}$ et la grille de $P_1$, il y a en parallèle une résistance R et une diode zener $D_3$.

La grille de $P_1$ est reliée par l'intermédiaire d'une diode $D_5$ au transistor $N_1$ de type N dont la grille reçoit le signal de commande a et dont la source est reliée à $V_{CC4}$, égal par exemple à 0 V.

La diode $D_5$ est là pour compenser l'effet de la diode intrinsèque du transistor $N_1$. Sans la diode $D_5$, cette diode intrinsèque passerait en direct lorsque $E_{-y}$ devient inférieur à $V_{CC4}$ et provoquerait une circulation de courant de $V_{CC4}$ vers $E_{-y}$.

La partie inférieure de la figure 5 comporte un montage similaire à celui de sa partie supérieure, avec les transistors $P_2$ et $N_2$, les diodes $D_4$ et $D_6$ et la résistance R, mais les types des transistors sont inversés et le signe du signal b est l'inverse de celui de a.

Entre $E_{-y}$, sortie de l'amplificateur $A_2$ et $V_y$, il y a la diode $D_2$ et entre $E_{+y}$, sortie de l'amplificateur $A_1$, et $V_y$, il y a la diode $D_1$ comme sur la figure 4.

Lorsque le transistor $N_1$ conduit, il y a circulation d'un courant qui déclenche la diode zener $D_3$, ce qui provoque la conduction du transistor $P_1$. L'interrupteur $I_1$ est fermé. La tension $E_{-y}$ est ainsi appliquée en $V_y$ et un courant est fourni à une électrode.

Au contraire, lorsque $N_1$ est bloqué, par la résistance R reliée à $E_{-y}$, le transistor $P_1$ est bloqué. L'interrupteur $I_1$ est ouvert.

Le montage de la partie inférieure de la figure 5 a le même type de fonctionnement que celui de la partie supérieure.

Il est bien entendu que le schéma de la figure 4 peut être réalisé en utilisant une autre technologie, en bipolaire par exemple.

Les diodes $D_1$ et $D_2$ sont en parallèle sur les diodes intrinsèques drain source des transistors $P_1$ et $N_2$. On peut supprimer les diodes $D_1$ et $D_2$ et renforcer les diodes intrinsèques de $P_1$ et $N_2$ pour qu'elles puissent supporter les courants nécessaires aux signaux d'entretien. cela permet aussi de diminuer les dimensions du circuit de commande.

Pendant l'intervalle d'inscription, c'est-à-dire de $t_1$ à $t_2$, il faut pour commander le transistor $P_1$ lui appliquer une tension grille inférieure à sa tension source.

Si la sortie $E_{-y}$ est à 0 V, il faut appliquer sur la grille de $P_1$ une tension négative. Il faut alors que la source du transistor $N_1$ soit à un potentiel négatif, égal à — $V_{CC1}$ par exemple. Cela oblige à disposer d'une alimentation continue basse tension égale à — $V_{CC1}$. Il faut aussi translater le niveau du signal de commande a entre — $V_{CC1}$ et 0 V.

On peut procéder différemment en laissant la source de $N_1$ à la masse, c'est-à-dire à $V_{CC4}$, et en créant une « marche » de quelques volts, égale à + $V_{CC1}$ par exemple, à la sortie $E_{-y}$ de l'amplificateur $A_2$ lors de l'inscription. On ne réduit pas la plage de fonctionnement du panneau à plasma, mais il faut modifier légèrement l'amplificateur $A_2$ en lui ajoutant la partie de faible puissance nécessaire pour créer cette « marche ».

Les schémas des figures 4 et 5 peuvent bien entendu être réalisés en circuit intégré ou en composants discrets.

Lorsque, comme cela sera le plus souvent le cas, les circuits d'interface basse tension/haute tension des figures 4 et 5 sont réalisés sous forme d'un circuit intégré Y comportant aussi un circuit logique et des réseaux de diodes comme sur la figure 1, il faut assurer la polarisation du substrat du circuit intégré.

Les tensions appliquées à ce circuit intégré varient entre — 100 V, $V_{CC3}$ et + 100 V, $V_{CC2}$ et il faut que le substrat du circuit intégré soit à la tension la plus négative du circuit.

Deux solutions sont alors envisageables :

— soit placer le substrat à un potentiel constant de — 100 V. Il faut alors disposer pour l'alimentation du substrat d'une tension continue égale à — 100 V, $V_{CC3}$. De plus cela oblige à disposer de composants supportant 200 V, soit $|V_{CC2}| + |V_{CC3}|$ par rapport au substrat ;

— soit créer pour le substrat une alimentation en créneaux variant entre $V_{CC4}$ et $V_{CC3}$, 0 V et — 100 V, et synchronisée sur $E_{+y}$ et $E_{-y}$, de façon à ce que le substrat du circuit intégré soit toujours à la tension la plus négative. Il suffit alors de disposer de composants supportant 100 V par rapport au substrat.

Dans la description précédente, on a pris comme exemple des tensions $V_{CC1}$, $V_{CC2}$, $V_{CC3}$ et $V_{CC4}$ égales respectivement à 12 V, + 100 V, — 100 V et 0 V. Il est bien entendu que ces tensions peuvent prendre des valeurs différentes.

**Revendications**

1. Circuit de commande d'un panneau à plasma de type alternatif, ce circuit assurant l'élaboration des signaux d'entretien, d'inscription et d'effacement du panneau, ces signaux étant appliqués entre deux électrodes appartenant à deux réseaux d'électrodes orthonogaux, un premier réseau d'électrodes étant commandé par des circuits intégrés (X) associés à un seul amplificateur et un second réseau d'électrodes étant commandé par des circuits intégrés (Y) associés à deux amplifi-cateurs ($A_1$, $A_2$), ces amplificateurs servant à l'élaboration des signaux d'entretien, chaque circuit intégré comportant notamment un circuit d'interface basse tension/haute tension (BT/HT) commandé par un circuit logique, ce circuit d'interface comportant des moyens permettant notamment, lors de l'élaboration des signaux d'inscription et d'effacement, de porter chaque électrode du panneau à une tension donnée, ce circuit d'interface étant suivi par un réseau de diodes ($D_1$, $D_2$), caractérisé en ce que les circuits d'interface basse tension/haute tension des circuits intégrés (Y) associés au second réseau d'électrodes sont alimentés en haute tension ($E_{+y}$, $E_{-y}$) par les deux amplificateurs ($A_1$, $A_2$) associés à chacun de ces circuits intégrés et en ce que lors de l'élaboration des signaux d'inscription et d'effacement, l'un des amplificateurs ($A_1$) fournit la tension ($E_{+y}$) à appliquer aux électrodes sélectionnées, à inscrire ou à effacer, alors que l'autre amplificateur ($A_2$) fournit la tension ($E_{-y}$) à appliquer aux électrodes non sélectionnées.

2. Circuit selon la revendication 1, caractérisé en ce que les circuits d'interface basse tension/haute tension (BT/HT) des circuits intégrés (Y) associés au second réseau d'électrodes sont constitués par deux interrupteurs ($I_1$, $I_2$, figure 4), commandés par un circuit logique et en série avec deux sources de courant ($C_1$, $C_2$), chaque interrupteur et sa source de courant étant montés, en parallèle avec une diode ($D_1$, $D_2$) du réseau de diodes, entre la sortie ($E_{+y}$, $E_{-y}$) de l'un des deux amplificateurs ($A_1$, $A_2$) associés à chaque circuit intégré et l'une des électrodes du réseau ($V_y$).

3. Circuit selon la revendication 2, caractérisé en ce que chaque interrupteur ($I_1$, $I_2$) en série avec une source de courant ($C_1$, $C_2$) est réalisé par un premier transistor MOS supportant une haute tension ($P_1$, $N_2$), monté en parallèle entre la sortie de l'un des amplificateurs ($A_1$, $A_2$) et l'une des électrodes du réseau ($V_y$), avec entre la grille de ce transistor ($P_1$, $N_2$) et la sortie de l'amplificateur ($E_{-y}$, $E_{+y}$) une résistance (R) en parallèle sur une diode zener ($D_3$, $D_4$) et entre la grille de ce transistor et une tension de polarisation ($V_{CC4}$, $V_{CC1}$) un second transistor MOS, de type différent du premier, supportant une haute ten-sion ($N_1$), commandé par un circuit logique (a, b).

4. Circuit selon la revendication 3, caractérisé en ce qu'une diode ($D_5$, $D_6$) est montée entre la grille du premier transistor ($P_1$, $N_2$) et le second transistor ($N_1$, $P_2$) pour compenser l'effet de la diode intrinsèque du second transistor.

5. Circuit selon l'une des revendications 1 à 4, caractérisé en ce que le substrat des circuits intégrés (Y) associés à deux amplificateurs ($A_1$, $A_2$) est porté à la tension la plus négative du circuit par une source de tension continue.

6. Circuit selon l'une des revendications 1 à 4, caractérisé en ce que le substrat des circuits intégrés (Y) associés à deux amplificateurs ($A_1$, $A_2$) est porté à la tension la plus négative du circuit par une alimentation en créneaux, synchronisée sur les sorties ($E_{+y}$, $E_{-y}$) des amplifi-cateurs ($A_1$, $A_2$).

**Claims**

1. A control circuit for a plasma display panel of the alternating type, said circuit ensuring the processing of the maintenance, write and delete signals for the panel, such signals being applied between two electrodes belonging to two orthogonal electrode arrays, a first array of electrodes being controlled by integrated circuits (X) associated with a single amplifier and a second array of electrodes being controlled by integrated circuits (Y) associated with two amplifiers ($A_1$ and $A_2$), such amplifiers serving for the processing of the maintenance signals, each integrated circuit more especially comprises a low voltage high voltage interface circuit (BT/HT) controlled by a logic circuit, said interface circuit comprising means for more especially permitting, at the time of the processing of the write and delete signals, the putting of each display panel at a given voltage, this interface circuit being followed by array of diodes ($D_1$ and $D_2$), characterized in that the low voltage high voltage interface circuits of the integrated circuits (Y) associated with the second electrode array are supplied with a high voltage ($E_{+y}$ and $E_{-y}$) by the two amplifiers ($A_1$ and $A_2$) associated with each of the integrated circuits and in that at the time of processing of the write and delete signals, one of the amplifiers ($A_1$) supplies the voltage ($E_{+y}$) to be supplied to selected electrodes, at which writing or deletion is to take place, while the other amplifier ($A_2$) supplies the voltage ($E_{-y}$) to be applied to the non-selected electrodes.

2. The circuit as claimed in claim 1 characterized in that the low voltage high voltage interface circuits (BT/HT) of the integrated circuits (Y) associated with the second electrode array are constituted by two break switches ($I_1$ and $I_2$, figure 4) controlled by a logic circuit and in series with two current sources ($C_1$ and $C_2$), each break switch and the source of current being arranged, in parallel with a diode ($D_1$ and $D_2$) of the diode array, between the output ($E_{+y}$ and $E_{-y}$) of one of the two amplifiers ($A_1$ and $A_2$) associated with each integrated circuit and one of the electrodes of the array ($V_y$).

3. The circuit as claimed in claim 2 characterized in that each break switch ($I_1$ and $I_2$) in series with a source of current ($C_1$ and $C_2$) is in the form of a first MOS transistor maintaining a high voltage ($P_1$ and $N_2$), placed in parallel between the output of one of the amplifiers ($A_1$ and $A_2$) and one of the electrodes of the array ($V_y$), with, between the gate of this transistor ($P_1$ and $N_2$) and the output of the amplifier ($E_{-y}$ and $E_{+y}$) a resistor ($R$) in parallel with a Zener diode ($D_3$ and $D_4$) and between the gate of this transistor and a polarizing voltage ($V_{CC4}$ and $V_{CC1}$) a second MOS transistor of a type different to the first one, maintaining a high voltage ($N_1$), controlled by logic circuits (a and b).

4. The circuit as claimed in claim 3 characterized in that one diode ($D_5$ and $D_6$) is placed between the gate of the first transistor ($P_1$ and $N_2$) and the second transistor ($N_1$ and $P_2$) in order to compensate the effect of the intrinsic diode of the second transistor.

5. The circuit as claimed in any one of the claims 1 through 4 characterized in that the substrate of the integrated circuits ($Y$) associated with the two amplifiers ($A_1$ and $A_2$) is placed at the most negative voltage of the circuit by a source of continuous voltage.

6. The circuit as claimed in any one of the claims 1 through 4 characterized in that the substrate of the integrated circuits ($Y$) associated with the two amplifiers ($A_1$ and $A_2$) is placed at the most negative voltage of the circuit by a pulsed supply, synchronized at the outputs ($E_{+y}$ and $E_{-y}$) of the amplifiers ($A_1$ and $A_2$).

**Patentansprüche**

1. Steuerschaltung für einen Plasmaschirm vom Wechselstromtyp, wobei diese Schaltung die Erzeugung von Aufrechterhaltungs-, Einschreibund Löschsignalen des Schirms gewährleistet, wobei diese Signale zwischen zwei zwei orthogonalen Elektrodennetzen angehörenden Elektroden angelegt sind, ein erstes Elektrodennetz über integrierte Schaltungen (X) gesteuert ist, die einem einzigen Verstärker zugeordnet sind, und wobei ein zweites Elektrodennetz über integrierte Schaltungen (Y) gesteuert wird, die zwei Verstärkern ($A_1$, $A_2$) zugeordnet sind, diese Verstärker der Ausarbeitung von Aufrechterhaltungssignalen dienen, jede integrierte Schaltung insbesondere eine Niederspannungs/Hochspannungs- Schnittstellenschaltung (BT/HT) umfaßt, die durch eine Logikschaltung gesteuert ist, diese Schnittstellenschaltung Mittel umfaßt, die es ermöglichen, insbesondere jede Elektrode des Schirms während der Erzeugung der Einschreibund Löschsignale auf eine bestimmte Spannung zu bringen, und wobei auf diese Schnittstellenschaltung ein Diodennetz ($D_1$, $D_2$) folgt, dadurch gekennzeichnet, daß die Niederspannungs/Hochspannungs- Schnittstellenschaltungen der dem zweiten Elektrodennetz zugeordneten integrierten Schaltungen (Y) mit Hochspannung ($E+_y$, $E-_y$) über die beiden Verstärker ($A_1$, $A_2$) versorgt werden, die jeder dieser integrierten Schaltungen zugeordnet sind, und daß bei der Erzeugung der Einschreibund Löschsignale einer der Verstärker ($A_1$) die an die selektierten Elektroden anzulegende Spannung ($E_{+y}$) zum Einschreiben oder zum Löschen liefert, während der andere Verstärker ($A_2$) die an die nicht selektierten Elektroden anzulegende Spannung ($E_{-y}$) liefert.

2. Schaltung nach Anspruch 1, dadurch gekennzeichnet, daß die Niederspannungs-/Hochspannungs (BT/HT)-Schnittstellenschaltungen der dem zweiten Elektrodennetz zugeordneten integrierten Schaltungen (Y) aus zwei Unterbrechern ($I_1$, $I_2$, Figur 4) bestehen, welche über eine Logikschaltung gesteuert und in Reihenschaltung mit zwei Stromquellen ($C_1$, $C_2$) liegen, wobei jeder Unterbrecher sowie seine Stromquelle mit einer Diode ($D_1$, $D_2$) des Diodennetzes zwischen dem Ausgang ($E_{+y}$, $E_{-y}$) eines der beiden Verstärker ($A_1$, $A_2$), die jeder integrierten Schaltung zugeordnet sind, und einer der Elektroden des Netzes ($V_y$), parallelgeschaltet sind.

3. Schaltung nach Anspruch 2, dadurch gekennzeichnet, daß jeder mit einer Stromquelle ($C_1$, $C_2$) in Reihe geschaltete Unterbrecher ($I_1$, $I_2$) aus einem ersten MOS-Transistor besteht, der einer Hochspannung ($P_1$, $N_2$) standhält und zwischen dem Ausgang eines der Verstärker ($A_1$, $A_2$) und einer der Elektroden des Netzes ($V_y$) parallelgeschaltet ist, wobei ein Widerstand ($R$) zu einer Zener-Diode ($D_3$, $D_4$) zwischen dem Gate dieses Transistors ($P_1$, $N_2$) und dem Ausgang des Verstärkers ($E_{-y}$, $E_{+y}$) parallelgeschaltet ist und wobei zwischen dem Gate dieses Transistors und einer zweiten Polarisationsspannung ($V_{CC4}$, $V_{CC1}$) ein zweiter, vom Typ des ersten verschiedener MOS-Transistor geschaltet ist, welcher einer Hochspannung ($N_1$) standhält und über eine Logikschaltung (a, b) gesteuert ist.

4. Schaltung nach Anspruch 3, dadurch gekennzeichnet, daß eine Diode ($D_5$, $D_6$) zwischen dem Gate des ersten Transistors ($P_1$, $N_2$) und dem zweiten Transistor ($N_1$, $P_2$) geschaltet ist, um den Eigen-Diodeneffekt des zweiten Transistors auszugleichen.

5. Schaltung nach einem der Ansprüche 1 bis 4, dadurch gekennzeichnet, daß das Substrat der zweier Verstärkern ($A_1$, $A_2$) zugeordneten integrierten Schaltungen (Y) über eine Gleichspannungsquelle auf die größte Negativspannung der Schaltung gelegt wird.

6. Schaltung nach einem der Ansprüche 1 bis 4, dadurch gekennzeichnet, daß das Substrat der zwei Verstärkern ($A_1$, $A_2$) zugeordneten integrierten Schaltungen (Y) an die größte Negativspannung der Schaltung über eine Rechteckversorgung, die mit den Ausgängen ($E_{+y}$, $E_{-y}$) der Verstärker ($A_1$, $A_2$) synchronisiert ist, gelegt wird.

**0 150 633**

## FIG_1

ORDRES LOGIQUES → CIRCUIT LOGIQUE

12V

Alimentations HT

BT→HT

$D_1$ $D_2$ $V_y$

$A_1$ E+y

CIRCUIT INTEGRE Y

$A_2$ E-y

## FIG_2

BT→HT

Vcc2, +100V

$C_1$ $I_1$ $D_1$ $A_1$ E+y $V_y$

$I_3$ c a

$C_3$ Vcc4 b $I_2$ E-y $A_2$

$C_2$ $D_2$

Vcc3, -100V

1

0 150 633

# FIG_3

# FIG_5

# FIG_4

2

0 150 633

FIG_6-a

FIG_6-b

FIG_6-c

FIG_6-d

FIG_6-e

ENTRETIEN INSCRIPTION EFFACEMENT

3